# EUROPÄISCHE PATENTSCHRIFT

(11) **EP 0 767 520 B1**
(45) Veröffentlichungstag und Bekanntmachung des Hinweises auf die Patenterteilung: **07.07.1999**
(21) Anmeldenummer: 96115005.9
(22) Anmeldetag: 19.09.1996
(51) Int. Cl.: H02B 1/56

(54) **Filterlüfter**
Fan with a filter
Ventilateur à filtre

(30) Priorität: 04.10.1995 DE 19536928
(43) Veröffentlichungstag der Anmeldung: 09.04.1997
(73) Patentinhaber: Rittal-Werk Rudolf Loh GmbH & Co. KG, 35745 Herborn (DE)
(72) Erfinder: Immel, Manfred, 35756 Mittenaar-Bicken (DE)
(74) Vertreter: Fleck, Hermann-Josef, Dr.-Ing.

(56) Entgegenhaltungen:
- DE-U- 8 707 975
- DE-U- 9 010 394
- DE-U- 9 306 032
- US-A- 4 517 880
- IBM TECHNICAL DISCLOSURE BULLETIN, Bd. 34, Nr. 11, April 1992, ARMONK, NY, Seiten 334-335, XP000303285 "Snap-lock Fan Holder"

## Beschreibung

Die Erfindung betrifft einen Filterlüfter für den Einbau in einen Durchbruch einer Wand eines Schaltschrankes mit einem ein Filter aufnehmendem Grundgehäuse, das mit einem Lamellengitter abgedeckt ist und dem Lamellengitter abgekehrt mit einem Lüfter verbunden ist.

Ein derartiger Filterlüfter ist aus der DE 90 10 394 U1 bekannt. In das Grundgehäuse ist das Filter eingesetzt und mit dem Lamellengitter abgedeckt. Auf der dem Lamellengitter abgekehrten Seite des Grundgehäuses ist ein Lüfter angebracht, wobei die Schraubverbindungen in den Eckbereichen des rechteckförmigen Grundgehäuses und Lüfters angeordnet sind. Die Eckbereiche des Grundgehäuses sind speziell ausgebildet, so daß der montierte Filterlüfter in den Durchbruch der Wand eingerastet werden kann.

Die Montage des Filterlüfters ist sehr zeitaufwendig und erfordert eine Vielzahl von Befestigungsmitteln, insbesondere dann, wenn aus Gründen der Berührungssicherheit die dem Grundgehäuse abgekehrte Seite des Lüfters noch mit einem Schutzgitter abgedeckt werden muß.

Die IBM Technical Disclosure Bulletin, Bd 34, No. 11, April 1992, Seiten 334-335 gibt ein Beispiel von einer Rast-Verbindung für die Montage eines Lüfters auf eine Halterung, wobei der Lüfter winkelversetzt an die Halterung angesetzt wird und rastend eindrehbar ist.

Es ist Aufgabe der Erfindung, einen Filterlüfter der eingangs erwähnten Art zu schaffen, bei dem der Teile- und Montageaufwand erheblich reduziert werden kann.

Diese Aufgabe wird nach der Erfindung dadurch gelöst, daß das Grundgehäuse zur Befestigung des Lüfters angespritzte Rastnocken aufweist, die in Bohrungen im zugekehrten Flansch des Lüfters einrasten, daß am Grundgehäuse weiterhin L-förmige Halteelemente angeformt sind, die dem dem Lamellengitter abgekehrten Flansch des Lüfters zugekehrt mit Rastnocken versehen sind, die in Bohrungen dieses Flansches einrasten, und daß die L-förmigen Halteelemente und das Grundgehäuse Aufnahmen bilden, in die der winkelversetzt an das Grundgehäuse angesetzte Lüfter rastend eindrehbar ist.

Die für die Befestigung des Lüfters am Grundgehäuse erforderlichen Teile sind Bestandteile der beiden miteinander zu verbindenden Einheiten. Die Montage beschränkt sich auf das winkelversetzte Ansetzen des Lüfters am Grundgehäuse und anschließenden Eindrehen des Lüfters bis zur Verrastung in den Aufnahmen.

Nach einer bevorzugten Ausgestaltung ist vorgesehen, daß das Grundgehäuse im wesentlichen quadratisch ausgebildet ist und in allen Eckbereichen angespritzte Rastnocken trägt, daß der Lüfter im wesentlichen rund ausgebildet ist und auf beiden Seiten im wesentlichen quadratische Flansche mit auf die Rastnocken des Grundgehäuses ausgerichteten Bohrungen aufweist, und daß die Eckbereiche der Flansche abgerundet sind.

Ist vorgesehen, daß die L-förmigen Halteelemente sich über einen Teil einer Seite des Flansches und einer anschließenden Rundung des Eckbereiches erstrecken, daß an allen Eckbereichen des Grundgehäuses die Halteelemente so angeformt sind, daß der Lüfter im Uhrzeigersinn in die Halteelemente eindrehbar ist, und daß die vier Halteelemente die vier Seiten des Flansches teilweise überdecken, dann beeinträchtigen die im Querschnitt L-förmigen Halteelemente das Eindrehen des Lüfters in die Aufnahmen nicht und geben gleichzeitig eine allseitige Festlegung des eingedrehten Lüfters.

Damit die Luftführung nicht beeinflußt wird, sieht eine weitere Ausgestaltung vor, daß die Rastnocken des Grundgehäuses am Boden desselben angeformt sind, der selbst gitterförmig ausgebildet ist.

Ist die dem Grundgehäuse abgekehrte Seite des Lüfters mit einem Schutzgitter abzudecken, dann wird unter Einbeziehung desselben die gleich einfache Montage des Filterlüfters dadurch erreicht, daß auf die dem Grundgehäuse abgekehrte Seite des Lüfters ein Schutzgitter aufrastbar ist, das an seinen Eckbereichen Laschen mit Rastnocken und Rastaufnahmen versehen ist, daß vor dem Eindrehen des Lüfters in die durch die L-förmigen Halteelemente und das Grundgehäuse gebildeten Aufnahmen die Rastnocken des Schutzgitters in die Bohrungen des zugekehrten Flansches des Lüfters eingesetzt bzw. eingerastet sind, und daß beim Eindrehen des Lüfters mit dem Schutzgitter die Rastnocken der Halteelemente in die Rastaufnahmen der Laschen des Schutzgitters einrasten. Dabei ist vorzugsweise vorgesehen, daß die Rastnocken und die Rastaufnahmen des Schutzgitters axial aufeinander ausgerichtet sind. Um einen ausreichend festen Sitz von Lüfter und Schutzgitter in den Aufnahmen zu erhalten, sieht eine vorteilhafte Ausgestaltung vor, daß der Abstand der Endschenkel der Halteelemente von dem Boden des topfartigen Grundgehäuses gleich der Bauhöhe von Lüfter plus Laschen des Schutzgitters entspricht.

Die Erfindung wird anhand eines in der Zeichnung dargestellten Ausführungsbeispiels näher erläutert. Es zeigen:
- Fig. 1: im Teilschnitt einen Filterlüfter mit der Festlegung des Lüfters durch winkelversetztes Ansetzen und Eindrehen in Aufnahmen des Grundgehäuses und
- Fig. 2: eine Teilansicht mit dem Endabschnitt eines L-förmigen Halteelementes.

Zunächst wird der Grundaufbau des Filterlüfters näher erläutert. Die Wand 10, z.B. eines Schaltschrankes, weist einen quadratischen Durchbruch 11 auf, in den der fertig montierte Filterlüfter eingesetzt, z.B. eingerastet wird.

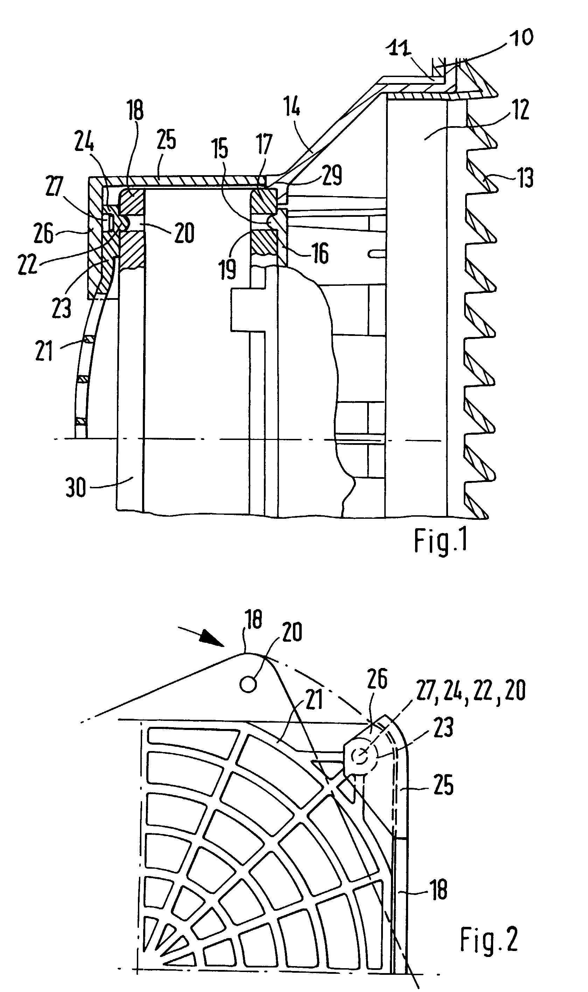

Der Filterlüfter weist ein topfartiges Grundgehäuse 14 auf, dessen Boden 16 gitterförmig ausgebildet ist, um den Luftdurchgang nicht unnötig zu erschweren. Das Grundgehäuse 14 nimmt eine Filtermatte 12 auf, die mit einem Lamellengitter 13 abgedeckt ist, das auch den Filterlüfter zur Außenseite hin abdeckt. Am Boden 16 sind in den vier Eckbereichen Rastnocken 15 angeformt. Der Lüfter 30 ist im Querschnitt im wesentlichen rund und an beiden Seiten mit im wesentlichen quadratischen Flanschen 17 und 18 abgeschlossen. Die Flansche 17 und 18 haben abgerundete Ecken, wie aus Fig. 2 zu entnehmen ist.

Die Flansche 17 und 18 haben in den überstehenden Eckbereichen Bohrungen 19 und 20, die auf die Rastnocken 15 des Grundgehäuses 14 ausrichtbar sind. Am Boden 16 des Grundgehäuses 14 sind zudem in den Eckbereichen L-förmige Halteelemente 25 angeformt, die mit dem Boden 16 des Grundgehäuses 14 Aufnahmen bilden, in die der winkelversetzt an das Grundgehäuse 14 angelegte Lüfter 30 eingedreht werden kann. Damit dies möglich ist, erstrecken sich die Halteelemente 25 über einen Teil einer Seite des Flansches 18 und die anschließende Rundung, wie der Fig. 2 zu entnehmen ist. Der Flansch 18 kann dann ungehindert eingedreht werden, wenn alle Halteelemente 25 im Uhrzeigersinn gleich angeordnet sind, so daß jede Seite des Flansches 18 von einem der Halteelemente 25 festgelegt ist. Dabei ist die Abstimmung so, daß der bis zum Anschlag eingedrehte Lüfter 30 mit dem Grundgehäuse 14 verrastet. Die Rastnocken 15 rasten in die Bohrungen 19 des Flansches 17 und an der Innenseite des Endabschnittes 26 der Halteelemente 25 angeformte, weitere Rastnocken 27 bringen eine weitere Verrastung.

Bevor der Lüfter 30 angesetzt und eingedreht wird, wird ein Schutzgitter 21 mit dem Flansch 18 des Lüfters 30 verbunden, z.B. verrastet. Dabei ist das Schutzgitter 21 in den Eckbereichen mit angeformten Laschen 23 versehen, die mit einem Rastnocken 22 und einer axial fluchtenden Rastaufnahme 24 versehen sind. Die Rastnocken 22 des Schutzgitters 21 werden in den Bohrungen 20 des Flansches 18 festgelegt, wie dem Schnitt nach Fig. 1 zu entnehmen ist. Daher bilden der Lüfter 30 und das Schutzgitter 21 eine Einheit, die winkelversetzt an das Grundgehäuse 14 angesetzt und in die Aufnahmen der Halteelemente 25 eingedreht werden können. Dabei rasten die Rastnocken 27 der Endabschnitte 26 der Halteelemente 25 in die Rastaufnahmen 24 der Laschen 23 des Schutzgitters 21 ein. Wie Fig. 1 zeigt, ist der Lüfter 30 mit dem Schutzgitter 21 damit rastend mit dem Grundgehäuse 14 verbunden. Die Endabschnitte 26 der Halteelemente 25 haben vom Boden 16 des Grundgehäuses 14 einen Abstand, der der Bauhöhe von Lüfter 30 und der Lasche 23 des Schutzgitters 21 entspricht.

Wird kein Schutzgitter 21 benötigt, dann rasten die Rastnocken 27 der Endabschnitte 26 der Halteelemente 25 direkt in die Bohrungen 20 des Flansches 18 ein. Der Abstand zwischen den Endabschnitten 26 der Halteelemente 25 und dem Boden 16 des Grundgehäuses 14 ist dann um die Dicke der Laschen 23 verkleinert, um eine eindeutige axiale Festlegung des Lüfters 30 am Grundgehäuse 14 zu erhalten.

## Patentansprüche

1. Filterlüfter für den Einbau in einen Durchbruch (11) einer Wand (10) eines Schaltschrankes mit einem ein Filter aufnehmendem Grundgehäuse (14), das mit einem Lamellengitter (13) abgedeckt ist und dem Lamellengitter (13) abgekehrt mit einem Lüfter (30) verbunden ist,
dadurch gekennzeichnet,
daß das Grundgehäuse (10) zur Befestigung des Lüfters (30) angespritzte Rastnocken (15) aufweist, die in Bohrungen (19) im zugekehrten Flansch (17) des Lüfters (16) einrasten,
daß am Grundgehäuse (14) weiterhin L-förmige Halteelemente (25) angeformt sind, die dem dem Lamellengitter (13) abgekehrten Flansch (18) des Lüfters (30) zugekehrt mit Rastnocken (27) versehen sind, die in Bohrungen (20) dieses Flansches (18) einrasten, und
daß die L-förmigen Halteelemente (25) und das Grundgehäuse (14) Aufnahmen bilden, in die der winkelversetzt an das Grundgehäuse (14) angesetzte Lüfter (30) rastend eindrehbar ist.

2. Filterlüfter nach Anspruch 1,
dadurch gekennzeichnet,
daß das Grundgehäuse (14) im wesentlichen quadratisch ausgebildet ist und in allen Eckbereichen angespritzte Rastnocken (15) trägt,
daß der Lüfter (30) im wesentlichen rund ausgebildet ist und auf beiden Seiten im wesentlichen quadratische Flansche (17,18) mit auf die Rastnocken (15) des Grundgehäuses (14) ausgerichteten Bohrungen (19,20) aufweist, und
daß die Eckbereiche der Flansche (17,18) abgerundet sind.

3. Filterlüfter nach Anspruch 1 oder 2,
dadurch gekennzeichnet,
daß die L-förmigen Halteelemente (25) sich über einen Teil einer Seite des Flansches (18) und einer anschließenden Rundung des Eckbereiches erstrecken,
daß an allen Eckbereichen des Grundgehäuses (14) die Halteelemente (25) so angeformt sind, daß der Lüfter (30) im Uhrzeigersinn in die Halteelemente (25) eindrehbar ist, und
daß die vier Halteelemente (25) die vier Seiten des Flansches (18) teilweise überdecken.

4. Filterlüfter nach einem der Ansprüche 1 bis 3,
dadurch gekennzeichnet,
daß die Rastnocken (15) des Grundgehäuses (14) am Boden (16) desselben angeformt sind, der selbst gitterförmig ausgebildet ist.

5. Filterlüfter nach einem der Ansprüche 1 bis 4,
dadurch gekennzeichnet,
daß auf die dem Grundgehäuse (14) abgekehrte Seite des Lüfters (30) ein Schutzgitter (21) aufrastbar ist, das an seinen Eckbereichen Laschen (23) mit Rastnocken (22) und Rastaufnahmen (24) versehen ist,
daß vor dem Eindrehen des Lüfters (30) in die durch die L-förmigen Halteelemente (25) und das Grundgehäuse (14) gebildeten Aufnahmen die Rastnocken (22) des Schutzgitters (21) in die Bohrungen (20) des zugekehrten Flansches (18) des Lüfters (30) eingesetzt bzw. eingerastet sind, und
daß beim Eindrehen des Lüfters (30) mit dem Schutzgitter (21) die Rastnocken (27) der Halteelemente (25) in die Rastaufnahmen (24) der Laschen (23) des Schutzgitters (21) einrasten.

6. Filterlüfter nach Anspruch 5,
dadurch gekennzeichnet,
daß die Rastnocken (22) und die Rastaufnahmen (24) des Schutzgitters (21) axial aufeinander ausgerichtet sind.

7. Filterlüfter nach Anspruch 5 oder 6,
dadurch gekennzeichnet,
daß der Abstand der Endschenkel (26) der Halteelemente (25) von dem Boden (16) des topfartigen Grundgehäuses (14) gleich der Bauhöhe von Lüfter (30) plus Laschen (23) des Schutzgitters (21) entspricht.

## Claims

1. Filter fan for installation in an opening (11) of a wall (10) of a switchgear cabinet, said fan having a basic housing (14) accommodating a filter, which housing is covered with a laminar lattice (13) and connected to a fan (30) remote from the laminar lattice (13), characterised in that the basic housing (14) has injection-moulded locking cams (15) for securing the fan (30), which cams engage in bores (19) in the facing flange (17) of the fan (30), in that L-shaped retaining elements (25) are also moulded on the basic housing (14) and are provided with locking cams (27) facing the flange (18) of the fan (30) remote from the laminar lattice (13), said locking cams engaging in bores (20) of this flange (18), and in that the L-shaped retaining elements (25) and the basic housing (14) form receiving means, in which can be lockingly inserted the fan (30) which is attached to the basic housing (14) in an angularly offset manner.

2. Filter fan according to claim 1, characterised in that the basic housing (14) has a substantially square configuration and is provided with injection-moulded locking cams (15) in all of the corner regions, in that the fan (30) has a substantially round configuration and has, on both sides, substantially square flanges (17, 18) provided with bores (19, 20) aligned with the locking cams (15) of the basic housing (14), and in that the corner regions of the flanges (17, 18) are rounded.

3. Filter fan according to claim 1 or 2, characterised in that the L-shaped retaining elements (25) extend over a portion of one side of the flange (18) and a subsequent rounding of the corner region, in that the retaining elements (25) are moulded on all of the corner regions of the basic housing (14) in such a manner that the fan (30) is insertable in the retaining elements (25) in a clockwise direction, and in that the four retaining elements (25) partially cover the four sides of the flange (18).

4. Filter fan according to one of claims 1 to 3, characterised in that the locking cams (15) of the basic housing (14) are moulded on the base (16) of said housing, which base itself has a lattice-like configuration.

5. Filter fan according to one of claims 1 to 4, characterised in that a protective lattice (21), which is provided at its corner regions with lugs (23) having locking cams (22) and locking receivers (24), is locatable onto the side of the fan (30) remote from the basic housing (14), in that, prior to the fan (30) being inserted in the receiving means formed by the L-shaped retaining elements (25) and the basic housing (14), the locking cams (22) of the protective lattice (21) are inserted or respectively locked in the bores (20) of the facing flange (18) of the fan (30), and in that, during the insertion of the fan (30) together with the protective lattice (21), the locking cams (27) of the retaining elements (25) engage in the locking receivers (24) of the lugs (23) of the protective lattice (21).

6. Filter fan according to claim 5, characterised in that the locking cams (22) and the locking receivers (24) of the protective lattice (21) are aligned axially with one another.

7. Filter fan according to claim 5 or 6, characterised in that the spacing between the end portions (26) of the retaining elements (25) and the base (16) of the cup-shaped basic housing (14) corresponds exactly to the overall height of the fan (30) and the lugs (23) of the protective lattice (21).

## Revendications

1. Ventilateur à filtre pour le montage dans un percement (11) d'une paroi (10) d'une armoire de distribution, avec un boîtier de base (14) recevant un filtre, ce dernier étant couvert d'une grille lamellaire (13) et étant relié, du côté opposé à la grille lamellaire, à un ventilateur (30),
caractérisé
en ce que le boîtier de base (10) présente, pour la fixation du ventilateur, des cames d'encliquetage (15) moulées par injection, qui s'encliquettent dans des forures (19) dans la bride (17) qui lui fait face du ventilateur (16),
en ce que sur le boîtier de base (14) sont formés en outre des éléments de support (25) en forme de L, lesquels orientés vers la bride (18) du ventilateur (30) qui est opposée à la grille lamellaire, présentent des cames d'encliquetage (27), qui s'encliquettent dans des forures (20) de cette bride (18), et
en ce que les éléments de support (25) en forme de L et le boîtier de base (14) forment des logements, dans lesquels peut être encliqueté par rotation le ventilateur (30) qui est monté avec décalage angulaire sur le boîtier de base (14).

2. Ventilateur à filtre suivant la revendication 1,
caractérisé
en ce que le boîtier de base (14) est en substance de forme quadrangulaire et présente dans toutes les régions d'angle des cames d'encliquetage (15) moulées par injection,
en ce que le ventilateur (30) est en substance de forme circulaire et présente des deux côtés des brides en substance quadrangulaires (17, 18) avec des forures (19, 20) alignées avec les cames d'encliquetage (15) du boîtier de base (14),
et en ce que les zones d'angle des brides (17, 18) sont arrondies.

3. Ventilateur à filtre suivant la revendication 1 ou 2
caractérisé
en ce que les éléments de support (25) en forme de L s'étendent au-dessus d'une partie d'un côté de la bride (18) et d'un arrondi y raccordé de la zone d'angle,
en ce que sur toutes les zones d'angle du boîtier de base (14), les éléments de support (25) sont formés de manière telle que le ventilateur (30) peut venir en engagement avec les éléments de support (25) par une rotation dans le sens des aiguilles d'une montre, et
en ce que les quatre éléments de support (25) chevauchent partiellement les quatre côtés de la bride (18).

4. Ventilateur à filtre suivant l'une quelconque des revendications de 1 à 3,
caractérisé
en ce que les cames d'encliquetage (15) du boîtier de base (14) sont formées sur le fond (16) de ce dernier, fond qui a lui-même la forme d'une grille.

5. Ventilateur à filtre suivant l'une quelconque des revendications de 1 à 4,
caractérisé
en ce que sur le côté du ventilateur (30) qui n'est pas orientée vers le boîtier de base (14) peut être encliquetée une grille de protection, dotée à ses zones d'angle de pattes (23) avec des cames d'encliquetage (22) et des logements d'encliquetage,
en ce qu'avant la mise en engagement par rotation du ventilateur (30) dans les logements formés part les éléments de support (25) et le boîtier de base (14), les cames d'encliquetage (22) de la grille de protection (21) avaient été introduites ou encliquetées dans les forures de la bride (18) qui leur fait face du ventilateur (30), et
en ce que lors de la rotation d'assujettissement du ventilateur (30) avec la grille de protection (21), les cames d'encliquetage (27) des éléments de support (25) s'encliquettent dans les logements d'encliquetage (24) des pattes (23) de la grille de protection (21).

6. Ventilateur à filtre suivant la revendication 5,
caractérisé
en ce que les cames d'encliquetage (22) et les logements d'encliquetage (24) de la grille de protection (21) sont en alignement axial.

7. Ventilateur à filtre suivant la revendication 5 ou 6
caractérisé
en ce que la distance entre les ailes terminales (26) des éléments de support (25) et le fond (16) du boîtier de base (14) en forme de pot correspond à la hauteur combinée du ventilateur (30) plus les pattes (23) de la grille de protection (21).
